Europäisches Patentamt

European Patent Office

Office européen des brevets

(19)

(11) Veröffentlichungsnummer: **0 234 245 B1**

(12) # EUROPÄISCHE PATENTSCHRIFT

(45) Veröffentlichungstag der Patentschrift: **04.12.91**

(51) Int. Cl.⁵: **H01R 4/64**, H05K 9/00

(21) Anmeldenummer: **87100620.1**

(22) Anmeldetag: **19.01.87**

(54) Gehäuse mit einschiebbaren elektronischen Schaltungsanordnungen.

(30) Priorität: **30.01.86 DE 3602817**

(43) Veröffentlichungstag der Anmeldung:
**02.09.87 Patentblatt 87/36**

(45) Bekanntmachung des Hinweises auf die
Patenterteilung:
**04.12.91 Patentblatt 91/49**

(84) Benannte Vertragsstaaten:
**AT DE FR GB IT**

(56) Entgegenhaltungen:
**DE-B- 2 653 216**
**DE-C- 976 848**

(73) Patentinhaber: **SIEMENS AKTIENGESELL-
SCHAFT**
**Wittelsbacherplatz 2**
**W-8000 München 2(DE)**

(72) Erfinder: **Kammerl, Franz, Dipl.-Ing. (FH)**
**Zollnergrabenweg 1**
**W-8411 Endlfeld(DE)**

## Beschreibung

Die Erfindung bezieht sich auf ein Gehäuse zum elektrischen Abschirmen, Schirmgehäuse, mit einschiebbaren elektronischen Schaltungsanordnungen auf einem Träger, insbesondere für Flachbaugruppen, wobei zwischen der elektronischen Schaltungsanordnung und dem Schirmgehäuse eine elektrische Kontaktierung erfolgt. Ein derartiges Gehäuse ist aus dem Patentschrift DE-B-2653 216 bekannt.

Wenn zwischen einer elektronischen Schaltungsanordnung, in der Regel mit Kupferbahnen und einer Abschirmung, meist aus Aluminium, elektrischer Kontakt herzustellen ist, verwendet man üblicherweise Leitkleber oder spezielle Pasten. Dadurch können auch bei unverträglichen Metallen, wie Aluminium und Kupfer es sind, Kontaktzonen gegen Umwandlern mit elektrisch isolierenden Oxidschichten geschützt werden. Als unverträgliche Metalle versteht man in der Kontakttechnik solche, die ein galvanisches Element ergeben können, wodurch Kontaktzonen oxidieren und korrodieren. Zum weiteren Schutz von Kontakten bei elektronischen Baugruppen verwendet man häufig Isolierlacke. Es ist auch gebräuchlich, gesonderte Verbindungsleitungen einzusetzen.

Leitkleber und Pasten sind sorgfältig aufzutragen, um den elektrischen Kontakt sicherzustellen. Bei Schirmgehäusen mit isolierender Oberfläche, sei es durch Oxidschichten oder Isolierlacke, sind darüber hinaus besondere Vorkehrungen zu treffen, daß der elektrische Kontakt zwischen der Abschirmung und der elektronischen Baugruppe in gewünschter Weise erreicht wird. Besondere Leitungen zu verlegen, ist in der Regel mühsam und arbeitsaufwendig und erfordert erneuten nachträglichen Schutz.

Der Erfindung liegt die Aufgabe zugrunde, ein Gehäuse mit einschiebbaren elektronischen Schaltungsanordnungen zu entwickeln, bei dem mit einfachen Mitteln eine Kontaktierung zwischen der elektronischen Schaltungsanordnung und dem Schirmgehäuse sichergestellt ist.

Die Lösung der geschilderten Aufgabe erfolgt nach der Erfindung dadurch, daß am Träger eine Ende ein es Federdrahtstücks solcher Länge randseitig mit den elektronischen Schaltungsanordnungen Kontaktgebend angeordnet ist, daß es an seinem anderen freien Ende unter einem spitzen Winkel zur Einschubrichtung über den Rand des Trägers weiter als um das Ausmaß des Abstandes des Trägers zum Schirmgehäuse vorsteht, derart, daß beim Einschieben des Trägers in das Schirmgehäuse sich das Federdrahtstück mit seinem freien Ende in die isolierende Oberflächenschichten des Schirmgehäuses kontaktgebend einschneidet.

Beim Einschieben des Trägers mit den elektronischen Anordnungen in das Schirmgehäuse schneidet sich also das Drahtstück mit seinem freien Ende in isolierende Oberflächenschichten des Schirmgehäuses ein und stellt dadurch während der Montage sozusagen selbsttätig den Kontakt sicher her. Darüber hinaus ist der Kontakt durch die benachbarte Oxidschicht oder durch den aufgebrachten Isolierlack geschützt. Man spricht in diesem Zusammenhang von einer gasdichten Verbindung. Auch der Federdruck trägt dazu bei, den Kontakt bleibend sicherzustellen.

Wenn das freie Ende des Federdrahtes scharfkantig ist, können isolierende Oberflächen eines Schirmgehäuses besonders sicher durchschnitten werden. Hierzu ist es vorteilhaft, wenn der Träger mit den elektronischen Schaltungsanordnungen in der Richtung in das Schirmgehäuse eingeführt wird, in die das Federdrahtstück mit seinem freien Ende weist. Das freie Ende stößt dann gegen das Schirmgehäuse. In anderen Fällen kann genügen, den Träger in der anderen Richtung einzuführen, so daß der Federdraht mit seinem freien Ende aufgleitet, was die Montage erleichtert.

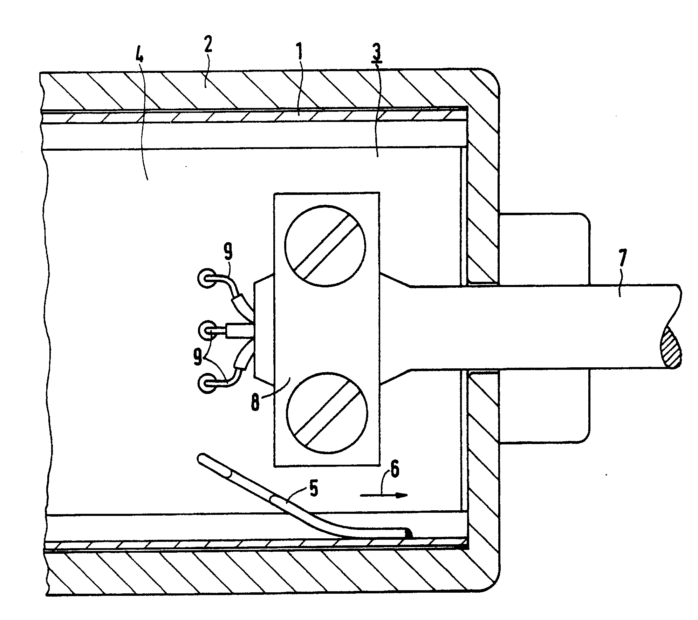

Die Erfindung soll nun anhand eines in der Zeichnung grob schematisch wiedergegebenen Ausführungsbeispiels näher erläutert werden:

In der Zeichnung ist ein Schirmgehäuse 1, zum elektrischen Abschirmen, in einem Außengehäuse 2 angeordnet. In das Schirmgehäuse, beispielsweise aus Aluminium, ist eine Flachbaugruppe 3 eingeschoben. Die Flachbaugruppe 3 besteht aus einem Träger 4, auf dessen Rückseite elektronische Schaltungsanordnungen, beispielsweise mit geätzten Kupferbahnen, angebracht sind. Am Träger 4 ist ein Federdrahtstück 5 randseitig angelötet. Es steht mit seinem freien Ende unter einem spitzen Winkel über den Rand des Trägers weiter vor, als es dem Ausmaß des Abstandes des Trägers 4 zum Schirmgehäuse entspricht. Im Ausführungsbeispiel kann man das Außengehäuse 2 als aufgeschnitten oder bei abgenommenen Deckel des Gehäuses dargestellt verstehen.

Der Träger 4 kann im Schirmgehäuse 1 geführt sein, so daß der Träger seitlich nicht ausweichen kann und der Abstand in etwa eingehalten bleibt. Wesentlich ist, daß das Federdrahtstück 5 eine solche Länge aufweist, daß es mit seinem freien Ende zum Schirmgehäuse Kontakt geben kann. Isolierende Oberflächen des Schirmgehäuses 1 werden besonders wirkungsvoll durchstoßen, wenn der Träger 4 in Richtung des Pfeils 6 in das Schirmgehäuse 1 eingeführt wird, in der das freie Ende des Federdrahtstücks 5 bezogen auf den Rand des Trägers 4 weist.

Wenn das Schirmgehäuse mit einem Isolierlack überzogen wurde, ist es günstig, das freie Ende des Federdrahtes scharfkantig auszubilden, um mit der Kante den Isolierlack durchdringen zu können. Es ist dann bei vielen Isolierlacken möglich, die Flachbaugruppe 3 trotzdem entgegen der Pfeilrichtung 6 in das Schirmgehäuse 1 einzuführen. Diese Einführungsrichtung hat den Vorteil, daß das Federdrahtstück 5 nicht gesondert zusammengebogen werden muß, um die Flachbaugruppe 3 in das Isoliergehäuse einführen zu können.

Im Ausführungsbeispiel wird das elektrische Gerät im Schirmgehäuse 1 und im Außengehäuse 2 von einer Zuleitung 7 versorgt. Hinter einer Zugentlastung 8 verlaufen die einzelnen Leiter 9 durch den Träger 4 hindurch zu den Schaltungsanordnungen auf der Rückseite.

## Patentansprüche

1. Gehäuse zum elektrischen Abschirmen, Schirmgehäuse (1), mit einschiebbaren elektronischen Schaltungsanordnungen auf einem Träger (4), insbesondere für Flachbaugruppen, wobei zwischen der elektronischen Schaltungsanordnung und dem Schirmgehäuse (1) eine elektrische Kontaktierung erfolgt, **dadurch gekennzeichnet,** daß am Träger (4) ein Ende ein es Federdrahtstücks (5) solcher Länge randseitig mit den elecktronischen Schaltungsanordnungen Kontaktgebend angeordnet ist, daß es an seinem anderen freien Ende unter einem spitzen Winkel zur Einschubrichtung über den Rand des Trägers weiter als um das Ausmaß des Abstandes des Trägers (4) zum Schirmgehäuse 1 hervorsteht, derart, daß beim Einschieben des Trägers (4) in das Schirmgehäuse (1) sich das Federdrahtstück (5) mit seinem freien Ende in die isolierende Oberflächenschichten des Schirmgehäuses (1) kontaktgebend einschneidet.

2. Gehäuse nach Anspruch 1, **dadurch gekennzeichnet,** daß das freie Ende des Federdrahtstückes (5) scharfkantig ist.

3. Gehäuse nach Anspruch 2, **dadurch gekennzeichnet,** daß das Schirmgehäuse (1) mit einem Isolierlack überzogen ist.

## Claims

1. Housing for the electrical screening, screen housing (1), with electronic circuit arrangements, which can be inserted, on a carrier (4), in particular for printed-circuit boards, whereby between the electronic circuit arrangement and the screen housing (1) an electrical contacting takes place, characterized in that on the carrier (4) on the edge there is arranged one end of a spring wire piece (5) contacting with the electronic circuit arrangements of such a length that on its other free end it projects under an acute angle to the insertion direction over the edge of the carrier further than by the extent of the distance of the carrier (4) to the screen housing (1), in such a way that with the insertion of the carrier (4) into the screen housing (1) the spring wire piece (5) cuts with its free end into the insulating surface layers of the screen housing (1) in contacting manner.

2. Housing according to claim 1, characterized in that the free end of the spring wire piece (5) is sharp-edged.

3. Housing according to claim 2, characterized in that the screen housing (1) is covered with an insulating varnish.

## Revendications

1. Boîtier pour réaliser une protection électrique, boîtier de blindage (1), comportant des montages électroniques pouvant être insérés, placés sur un support (4), notamment pour des modules plats, et dans lequel un contact électrique est établi entre le montage électronique et le boîtier de blindage (1), caractérisé par le fait qu'au niveau du bord est disposée, sur le support (4), de manière à établir des contacts avec des montages électroniques, une extrémité d'un élément de ressort en forme de fil (5) possédant une longueur telle qu'au niveau de son autre extrémité libre, il fait saillie en faisant un angle aigu par rapport à la direction d'insertion, au-delà du bord du support, et ce sur une distance supérieure à la distance entre le support (4) et le boîtier de blindage (1), de sorte que, lors de l'insertion du support (4) dans le boîtier de blindage (1), l'extrémité libre de l'élément de ressort en forme de fil (5) s'enfonce dans les couches superficielles isolantes du boîtier de blindage (1) en établissant le contact.

2. Boîtier suivant la revendication 1, caractérisé par le fait que l'extrémité libre de l'élément de ressort en forme de fil (5) possède une arête vive.

3. Boîtier suivant la revendication 2, caractérisé par le fait que le boîtier de blindage (1) est recouvert d'une laque isolante.